# EUROPEAN PATENT SPECIFICATION

(11) **EP 3 577 526 B1**
(45) Date of publication and mention of the grant of the patent: **02.04.2025**
(21) Application number: 18748118.9
(22) Date of filing: 01.02.2018
(51) Int. Cl.: G05B 13/04, H04L 12/28

(54) **SYSTEM FOR MODEL CENTRIC DATA STORAGE**
SYSTEM ZUR MODELLZENTRISCHEN DATENSPEICHERUNG
SYSTÈME DE MÉMORISATION DE DONNÉES CENTRÉE SUR UN MODÈLE

(30) Priority: 01.02.2017 US 201715422287
(43) Date of publication of application: 11.12.2019
(73) Proprietor: Honeywell International Inc., Morris Plains, NJ 07950 (US)
(72) Inventor: PARTHASARATHY, Girija, Morris Plains, NJ 07950 (US)
(74) Representative: Houghton, Mark Phillip
(86) International application number: PCT/US2018/016399
(87) International publication number: WO 2018/144704

(56) References cited:
- EP-A2- 2 659 319
- EP-A2- 3 382 491
- US-A1- 2012 002 951
- US-A1- 2014 000 836
- US-A1- 2015 331 023
- US-A1- 2016 054 018
- US-A1- 2016 357 208

## Description

### Technical Field

The present disclosure relates to methods, devices, systems, and computer-readable media for model centric data storage.

### Background

A number of devices can be utilized to control and/or manage an interior environment of a building (e.g., house, office building, etc.). In some examples, a thermostat can be utilized to monitor temperature within the building and control other devices such as a heating, ventilation, and air conditioning (HVAC) system. Thermostats can be utilized to monitor and store data relating to the environment within the building. In some examples, the thermostat can be connected to a network of devices (e.g., internet, etc.).

The thermostat within a building can generate a relatively large quantity of data that can require storage space and/or bandwidth to upload to a remote storage device. Increased storage space and/or increased bandwidth can be required when increasing the quantity of data to be monitored and/or a quantity of data to be generated. This data can be very valuable to monitor and store, but can also be relatively expensive with the increased storage capacity required to store the data.

EP3382491A2 discloses an intelligent-thermostat-controlled environmental-conditioning system in which computational tasks and subcomponents with associated intelligent-thermostat functionalities are distributed to one or more of concealed and visible portions of one or more intelligent thermostats and, in certain implementations, to one or more intermediate boxes. The intelligent thermostats are interconnected to intermediate boxes by wired and/or wireless interfaces and intelligent thermostats intercommunicate with one another by wireless communications. Wireless communications include communications through a local router and an ISP, 3G and 4G wireless communications through a mobile service provider. Components of the intelligent-thermostat-controlled environmental-conditioning system may also be connected by wireless communications to remote computing facilities.

### Brief Description of the Drawings

Figure 1 is an example of a system for model centric data storage consistent with the present disclosure.
Figure 2 is an example of a system for model centric data storage consistent with the present disclosure.
Figure 3 is an example of a method for model centric data storage consistent with the present disclosure.
Figure 4 is an example of a diagram of a computing device for model centric data storage consistent with one or more embodiments of the present disclosure.

### Detailed Description

The present invention in its various aspects is as set out in the appended claims. Devices, methods, systems, and computer-readable media for model centric data storage are described herein. According to the invention a system for model centric storage is defined in claim 1. The dependent claims define further advantageous embodiments.

The model centric data storage can be utilized to lower storage and/or bandwidth requirements of a system while providing thermal models of the building. The thermal models can be utilized to identify model parameters. The model parameters and/or thermal models can be stored instead of sensor data to lower storage and/or bandwidth requirements. For example, a plurality of sensors can be utilized to monitor an environment within a building.

The plurality of sensors can be utilized to monitor temperatures within the building and/or device activation within the building. In this example, the plurality of sensors can generate a relatively large quantity of data and a portion of the data can be extracted for generating a thermal model of the building. The model parameters from the thermal model can be extracted and stored in memory while the sensor data is discarded or deleted. The model parameters can be utilized to generate predicted sensor data and/or predicted environment data for the building.

In some examples, the model parameters can be utilized to regenerate the sensor data from the plurality of sensors, which can allow the system to discard or delete the sensor data. The model parameters can be stored with less memory space and/or be sent to a database with less bandwidth compared to the sensor data. The model parameters can utilize streaming data to generate predicted environment data within the building. For example, real time data can be utilized as inputs with the model parameters to predict environmental conditions within the building for a plurality of different time periods. In another example, the real time data can be utilized to predict when devices within the building will be activated and/or when devices within the building will be deactivated. For example, the real time data can be utilized to determine when an HVAC system will be activated or deactivated during a plurality of different time periods.

In the following detailed description, reference is made to the accompanying drawings that form a part hereof. The drawings show by way of illustration how one or more embodiments of the disclosure may be practiced.

These embodiments are described in sufficient detail to enable those of ordinary skill in the art to practice one or more embodiments of this disclosure.

The proportion and the relative scale of the elements provided in the figures are intended to illustrate the embodiments of the present disclosure, and should not be taken in a limiting sense.

The figures herein follow a numbering convention in which the first digit corresponds to the drawing figure number and the remaining digits identify an element or component in the drawing. Similar elements or components between different figures may be identified by the use of similar remaining digits.

As used herein, "a" or "a number of" something can refer to one or more such things. For example, "a number of devices" can refer to one or more devices. Additionally, the designator "N", as used herein, particularly with respect to reference numerals in the drawings, indicates that a number of the particular feature so designated can be included with a number of embodiments of the present disclosure.

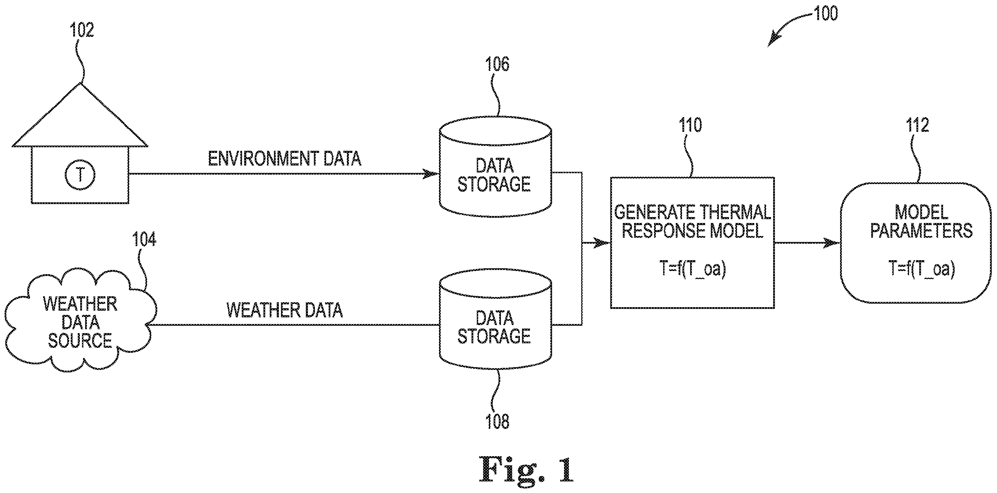

Figure 1 is an example of a system 100 for model centric data storage consistent with the present disclosure. The system 100 can be utilized to generate models such as thermal response models for a building. For example, the system 100 can be utilized to generate a thermal response model for a house or office building. The thermal response models can be utilized to identify model parameters that can be utilized to predict environment conditions within the building and/or device activation or deactivation within the building. The system 100 can utilize the predictions to identify unsafe temperatures within the building, predict HVAC activation, predict HVAC deactivation, compare energy efficiency of similar buildings, recreate environmental conditions for a historical reference, and/or identify demand response devices to deactivate.

The system 100 can include building data 102. The building data 102 can include sensor data corresponding to the building. The sensor data can include, but is not limited to: temperature sensor data from a thermostat, temperature sensor data from a sensor coupled to the thermostat, HVAC sensor data, moisture sensor data, and/or other state sensors corresponding to the environment within the building.

The building data 102 can be high frequency high resolution (HFHR) data. As used herein, HFHR data refers to time series data that updates at a relatively rapid frequency (e.g., updates each second, updates every fraction of a second, etc.). For example, the building data 102 can be collected by the plurality of sensors every second or every fraction of a second. In this example, the building data 102 can include temperature data within the building, state data of a thermostat, settings of a thermostat, settings of an HVAC system, activation of the HVAC system, and/or deactivation of the HVAC system. In some examples, the building data 102 can be relatively precise building data. For example, the building data can include precise temperature data that includes at least three significant figures (e.g., 70.3°F) compared to less precise temperature data that includes two significant figures (e.g., 71°F).

The building data 102 can include time stamps to identify the building data 102 with a particular time period. For example, the temperature data can include a time stamp to identify a time period when the temperature data was collected. In another example, the settings of the HVAC system can include a time stamp to identify a time period when the settings of the HVAC system were determined.

The time stamps can be utilized to organize the building data 102 for a particular time period. For example, the building data 102 can be collected for the time period of 30 days. In this example, the building data 102 that includes time stamps within the 30 day time period can be stored in data storage 106. The time stamps can be utilized to correlate the building data 102 within the data storage 106 such that the building data 102 with different time stamps can be compared based on the time period of the building data 102.

The system 100 can include weather data 104 and/or exterior environment data for the building. For example, the weather data 104 can include environment data outside the building. The environment outside the building can affect the environment within the building. For example, relatively colder temperatures outside the building can cause the environment inside the building to cool at a relatively faster pace.

The weather data 104 can include corresponding time stamps to identify a time when the weather data 104 was collected or determined. The time stamps can be utilized similarly to the time stamps corresponding to the building data 102. For example, the weather data 104 can be organized based on the time stamps. In some examples, the weather data 104 can be stored in data storage 108.

The data stored in data storage 106 and the data stored in data storage 108 can be utilized to generate a model at 110. The model generated at 110 can be a thermal response model for the building that corresponds to the stored data within data storage 106 and stored data within data storage 108. For example, data corresponding the inside of the building can be extracted from the data storage 106 for a particular time period (e.g., 1 month period, etc.). In this example, data corresponding to the outside of the building can be extracted from the data storage 108.

The generated model at 110 can be a thermal response model of the building. In some examples, the thermal response model of the building can be a function of the weather data 104 for the building. That is, the thermal response model can represent temperature within the building over a time period with corresponding temperatures outside the building over the same time period. As described herein, the environment outside the building can affect the environment inside the building. Thus, the thermal response model can be a function of the environment outside the building affecting the environment inside the building over time.

The generated model at 110 can be a polynomial model such as auto-regressive exogenous (ARX) models. In some examples, the model at 110 can be generated based on a function of the weather data and an initial interior temperature of the building. In some examples, the model at 110 can utilize an outdoor temperature of the building to determine a predicted indoor temperature of the building. The model at 110 can include a steps ahead prediction (e.g., five steps ahead prediction model) that can utilize an actual indoor temperature within the building to predict "five future steps" instead of utilizing previously predicted indoor temperatures.

The generated model at 110 can be utilized to extract model parameters at 112. The model parameters can be a function of the environment outside the building affecting the environment inside the building. The model parameters can be utilized to provide inputs that can be utilized to predict the environment inside the building and/or predict a state of devices inside the building for a time period based on weather data corresponding to the time period. For example, weather data can be input into the model parameters to generate a predictive model of the environment inside the building and/or generate a predictive model of the state of devices inside the building.

Predicting the environment inside the building can include predicting a temperature within the building based on providing inputs into the model parameters. Predicting the state of the devices inside the building can include predicting when a device is activated and/or predicting when a device is deactivated for a time period. In some examples, predicting the state of the devices inside the building can be utilized to determine demand response devices to deactivate and/or activate.

As described further herein, when the model parameters are extracted, the generated model at 110 can be discarded or deleted from the system 100. In addition, the building data 102 and the weather data 104 can be utilized to generate the model at 110 and can be discarded or deleted from the system 100. Thus, storage and/or bandwidth can be reduced by only storing the model parameters extracted at 112 compared to storing or transmitting the building data 102 and/or the weather data 104. In some examples, the weather data 104 may not be stored in a database and may be obtained from a different source than the building data 102. As described further herein, the model parameters can utilize streaming data to predict the environment inside the building. As used herein, streaming data can include data that is not stored and retrieved from memory.

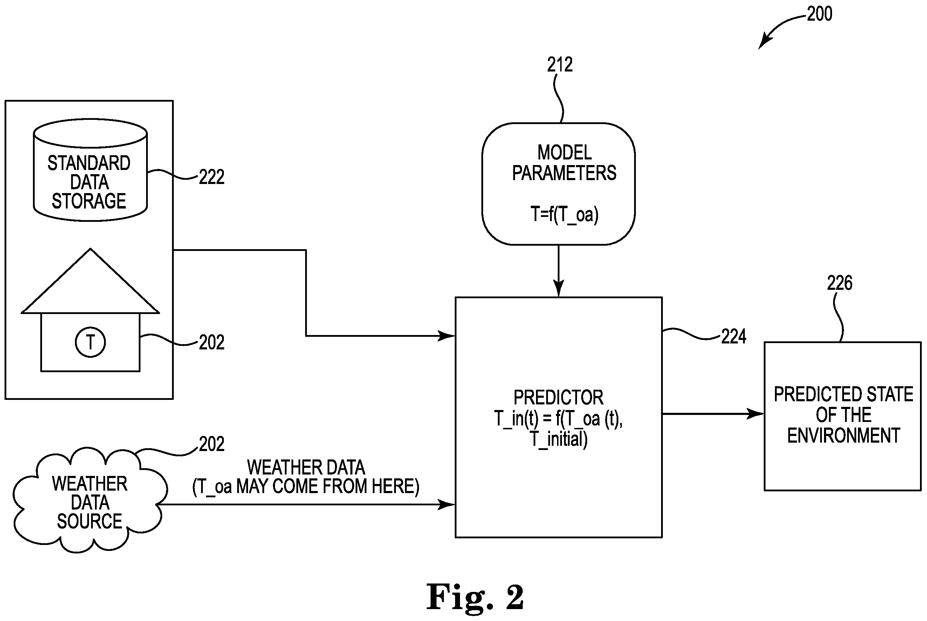

Figure 2 is an example of a system 200 for model centric data storage consistent with the present disclosure. The system 200 can represent a system that utilizes the model parameters 212 that are generated by a system 100 as referenced in Figure 1. The system 200 can utilize the model parameters 212 with streaming data to determine a predicted environment of a building without saving the streaming data or by only saving the model parameters 212. This can reduce storage and/or bandwidth as described herein.

The system 200 can include building data 202. As described herein, the building data 202 can include data relating to an environment within or inside a particular building. In some examples, the building data 202 can include real time data of temperature inside the building, real time data of activation or deactivation of devices inside the building, and/or other data relating to the building.

The system 200 can include storage data 222. The storage data can include historical data relating to the building. In some examples, the storage data 222 can be historical building data that is the same or similar as the building data 202. For example, the storage data 222 can be historical data relating to temperatures inside the building, activation or deactivation of devices inside the building, and/or other historical data relating to the building.

The system 200 can include weather data 204. As described herein, the weather data can include environment data outside the building. The environment outside the building can affect the environment inside the building. The weather data 204 can include temperature data outside the building.

The system 200 can include generated model parameters 212. The model parameters 212 can be generated as described herein in reference to Figure 1. As described herein, the model parameters 212 can be stored instead of storing data (e.g., building data 202, weather data 204, high frequency high resolution (HFHR data, etc.). The model parameters can be utilized by a predictor 224 to determine a predicted state of the environment 226 for the building (e.g., a predicted model, predicted air temperature, etc.).

The system 200 can include a predictor 224 that utilizes the model parameters 212 to determine a predicted state of the environment 226 utilizing streaming data. The streaming data can include weather data 204, building data 202, and/or storage data 222 that is utilized to determine a predicted state of the environment 226 and discarded upon determination of the predicted state of the environment 226.

In some examples, the streaming data can be delta data. As used herein, delta data includes data representing a change from a previous data point. For example, delta data can include a data point where the previous data point was different. In another example, the delta data can include weather data 204 where a temperature outside the building changes from 70° Fahrenheit (F) to 71° F. In this example, the delta data from the weather data 204 can be utilized by the predictor 224. In some examples, non-delta data may not be utilized by the predictor 224. As used herein, non-delta data includes a data point where the previous data point is the same.

By utilizing only delta data the system 200 can reduce processing, storage, and/or bandwidth requirements of the predictor 224. For example, relatively less data may be stored for utilization by the predictor 224 and relatively less bandwidth may be utilized when sending the delta data to the predictor 224. In some examples, the predictor 224 can utilize delta weather data 204 and delta state data of devices inside the building.

The predictor 224 can predict a temperature inside the building (T_in(t)) at a particular time period based on the model parameters 212. In some examples, the predictor 224 can utilize the weather data 204 to determine a temperature outside the building (T_oa) at a particular time to predict the temperature inside the building at the particular time. In some examples, the predictor 224 can utilize an initial temperature inside the building (T_initial) at a particular time to predict the temperature inside the building at the particular time. The predictor 224 can also utilize state data for devices inside the building at a particular time period to predict the temperature inside the building at the particular time period.

The predictor 224 can utilize the model parameters 212 to determine a predicted state of the environment 226 based on a combination of weather data 204 and building data 202. For example, the predictor 224 can determine a predicted state of the environment 226 for a building based on a temperature outside the building and an activation state of an HVAC system of the building. In some examples, the predictor 224 can receive and/or utilize delta data. As described herein, delta data includes a data point that is altered from a previous data point.

In some examples, the predictor 224 can receive and/or utilize streaming data from the building data 202, storage data 222, and/or weather data 204. As used herein, steaming data can include data that is received by the predictor 224 and discarded instead of stored. Utilizing streaming data instead of stored data can lower bandwidth of communication with the predictor 224 and/or lower storage requirements of the predictor 224. In some examples, the streaming data can be utilized by the predictor 224 to determine delta data. For example, the predictor 224 can receive streaming data from the weather data 204 and/or the building data 202 to determine when there is a change in data points to identify the delta data. In these examples, the delta data can be utilized to determine a predicted state of the environment.

In some examples, the predictor 224 can utilize low-resolution data from the building data 202 and/or weather data 204. As used herein, the low-resolution data can be estimated data or relatively less accurate data from a plurality of sensors. For example, high-resolution data can include a temperature data point of 70.159° F. In this example, corresponding low-resolution data can be 70° F.

The predicted state of the environment 226 generated by the predictor 224 can be a visual representation of predicted temperature data for the inside of a building over a time period. The predicted state of the environment 226 can also include a visual representation of a predicted state of devices inside the building. In some examples, the predicted state of devices can include a predicted activated state of the devices and/or a predicted deactivated state of the devices over a time period. The predicted state of the environment 226 can include a visual representation of energy efficiency of the building over a period of time.

The energy efficiency of the building can represent a change in temperature inside the building over time under a plurality of different conditions (e.g., temperature outside the building, activation duration of devices inside the building, etc.). The energy efficiency of the building can be utilized to identify areas of energy loss from inside the building. For example, the areas of energy loss can include, but are not limited to: windows, insulation defects, and/or extreme temperatures outside the building.

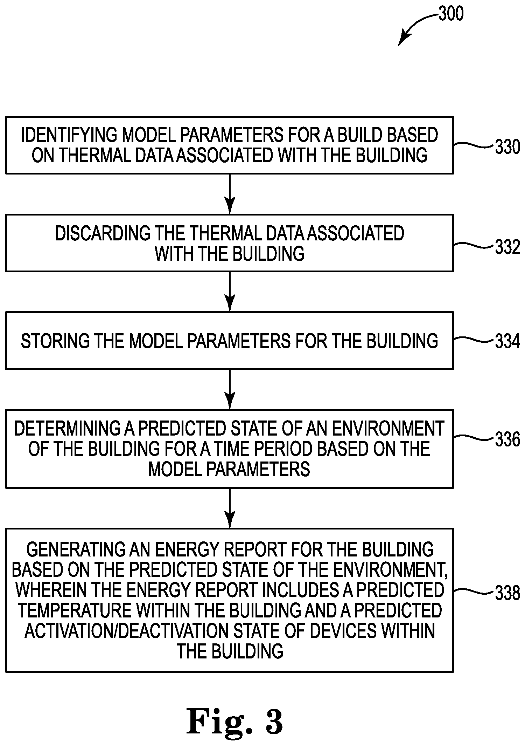

Figure 3 is an example of a method 300 for model centric data storage consistent with the present disclosure. The method 300 can be executed by a computing device as described herein and/or implemented within a system as described herein. The method 300 can be utilized to determine a predicted state of an environment inside a building, an efficiency of the building, and/or device activation and deactivation over a time period.

At 330 the method 300 can include identifying model parameters for a building based on thermal data associated with the building. As described herein, a thermal model of a building can be generated utilizing stored data corresponding to the building. In some examples, the model parameters can be identified from the thermal model of the building. The model parameters can be utilized by a predictor to determine a predicted state of the environment as described herein.

At 332 the method 300 can include discarding the thermal data associated with the building. As described herein, the thermal data of the building, weather data corresponding to the building, and/or other data relating to the building can be utilized by the predictor and/or model parameters to determine a predicted state of the environment. In some examples, the thermal data associated with the building can be discarded or deleted when the thermal data is utilized by the predictor. The thermal data can be streaming data that is analyzed to determine delta data as described herein. The thermal data can be regenerated by the predictor and/or the model parameters in case the thermal data for a particular time period is to be utilized later.

As described herein, utilizing streaming thermal data can lower the cost of storing relatively large quantities of data and streaming thermal data can also lower bandwidth requirements. In some examples, the streaming thermal data can be discarded and identified delta thermal data can be utilized by the predictor.

At 334 the method 300 can include storing the model parameters for the building. As described herein, only the model parameters may be stored to reduce storage requirements of the system. The model parameters can be utilized to regenerate specific temperature data for a particular time period. This can allow the system to discard the thermal HFHR data until it is needed and then regenerate the thermal data.

At 336 the method 300 can include determining a predicted state of an environment of the building for a time period based on the model parameters. As described herein, a predictor can utilize the model parameters to determine a predicted state of an environment of the building (e.g., temperature within the building, etc.) and/or a predicted thermal model of the building for a plurality of different time periods. In some examples, the predictor can generate simulated thermal models for a building based on simulated data instead of real time data.

At 338 the method 300 can include generating an energy report for the building based on the predicted state of the environment, wherein the energy report includes a predicted temperature within the building and a predicted activation/deactivation state of devices within the building. The energy report can include an energy efficiency of the building over time.

In some examples, the method 300 can include regenerating the thermal data associated with the building for a time period utilizing the model parameters for the building. As described herein, the thermal data doesn't need to be stored by a system. For example, the thermal data can be regenerated utilizing the model parameters for the building.

In some examples, the method 300 can include predicting device activation and device deactivation for the devices within the building utilizing the model parameters for the building. As described herein, predicting device activation and/or device deactivation can include predicting when a device will be in an on state or when a device will be in an off state. For example, predicting device activation and device deactivation can include predicting when an HVAC unit for a building will be activated and predicting when the HVAC unit for the building will be deactivated. In this example, the HVAC unit can be a demand response device for a utility company and the predictions can be utilized to determine if or when the HVAC unit should be deactivated or provided lower resources.

In some examples, the method 300 can include predicting future indoor temperature of the building utilizing the model parameters for the building. As described herein, predicting future indoor temperature of the building can be utilized to determine when to activate or deactivate devices relating to the building. In some examples, the future indoor temperature can be utilized to determine a time to activate and/or a time to deactivate an HVAC unit.

The energy report can analyze efficiency degradation of the building over time and/or degradation of devices inside the building over time. For example, the energy report can be utilized to compare energy efficiency of a building for a first time period and a second time period. In this example, a HVAC system may start running for longer periods of time compared to previous predicted states of the environment, which can indicate that the HVAC system may be degrading or failing.

The energy report can also analyze efficiency degradation of insulation within the building. For example, the energy report can identify that the thermal model of the building indicates that there is relatively more heat loss compared to previous thermal models for the building. The energy report can be a visual representation of changes occurring in the thermal response of a building over time.

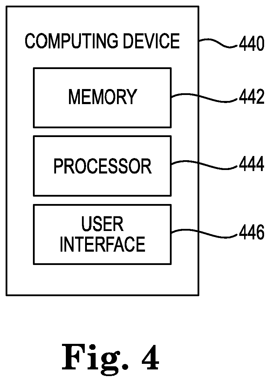

Figure 4 is an example of a diagram of a computing device 440 for a dynamic temperature sensor consistent with one or more embodiments of the present disclosure. Computing device 440 can be, for example, an embedded system as described herein, among other types of computing devices. For example, the computing device 440 can be utilized to perform a method 300 as referenced in Figure 3.

In some examples, the computing device 440 can generate a thermal model for a building based on state data for an environment with the building and state data for heating and cooling devices within the building. The computing device 440 can determine a number of parameters for the thermal model based on a determined number of inputs for the thermal model.

The computing device 440 can discard the state data for the environment of the building and state data for the heating and cooling devices within the building. In certain embodiments, the computing device 440 can store the number of parameters.

The computing device 440 can also generate an energy report for the building that includes predicted state data for the environment and predicted state data for the heating and cooling devices within the building over a selected time period.

As shown in Figure 4, computing device 440 includes a memory 442 and a processor 444 coupled to user interface 446. Memory 442 can be any type of storage medium that can be accessed by processor 444, which performs various examples of the present disclosure. For example, memory 442 can be a non-transitory computer readable medium having computer readable instructions (e.g., computer program instructions) stored thereon.

Processor 444 executes instructions to provide a variable voltage to a sensor based on signals from the sensor in accordance with one or more embodiments of the present disclosure. Processor 444 can also determine when a signal from the sensor is below a first threshold. Processor 444 can also increase or decrease a voltage to the sensor.

Further, although memory 442, processor 444 and user interface 446 are illustrated as being located in computing device 440, embodiments of the present disclosure are not so limited. For example, memory 442 can also be located internal to another computing resource (e.g., enabling computer readable instructions to be downloaded over the Internet or another wired or wireless connection). Part of the memory can be storage in a cloud storage. Processor 444 can be a cloud computer.

As shown in Figure 4, computing device 440 can also include a user interface 446. User interface 446 can include, for example, a display (e.g., a screen, an LED light, etc.). The display can be, for instance, a touch-screen (e.g., the display can include touch-screen capabilities). User interface 446 (e.g., the display of user interface 446) can provide (e.g., display and/or present) information to a user of computing device 440.

Additionally, computing device 440 can receive information from the user of computing device 440 through an interaction with the user via user interface 446. For example, computing device 440 (e.g., the display of user interface 446) can receive input from the user via user interface 446. The user can enter the input into computing device 440 using, for instance, a mouse and/or keyboard associated with computing device 440, or by touching the display of user interface 446 in embodiments in which the display includes touch-screen capabilities (e.g., embodiments in which the display is a touch screen).

As used herein, "logic" is an alternative or additional processing resource to execute the actions and/or functions, etc., described herein, which includes hardware (e.g., various forms of transistor logic, application specific integrated circuits (ASICs), etc.), field programmable gate arrays (FPGAs), as opposed to computer executable instructions (e.g., software, firmware, etc.) stored in memory and executable by a processor.

The scope of the various embodiments of the disclosure includes any other applications in which the above structures and methods are used. Therefore, the scope of various embodiments of the disclosure should be determined with reference to the appended claims.

In the foregoing Detailed Description, various features are grouped together in example embodiments illustrated in the figures for the purpose of streamlining the disclosure. This method of disclosure is not to be interpreted as reflecting an intention that the embodiments of the disclosure require more features than are expressly recited in each claim.

Rather, as the following claims reflect, inventive subject matter lies in less than all features of a single disclosed embodiment. Thus, the following claims are hereby incorporated into the Detailed Description, with each claim standing on its own as a separate embodiment.

## Claims

1. A system for model centric data storage, comprising:
a computing device configured to:
extract environmental data (102) and weather data (104) within a first time period from a number of sensors utilized to determine state data for an environment within a building and state data for devices within the building;
generate a thermal response model (110) of the building based on the extracted data;
use the generated thermal response model (110) to extract one or more model parameters (112, 212) that are adapted to predict the environment inside the building and/or predict a state of devices inside the building based on environmental and weather data from the number of sensors during a second time period subsequent to the first time period;
store the model parameters (112, 212);
discard the generated thermal response model (110) data; and
determine a predicted state of the environment (226) within the building and a predicted state of the devices within the building for the second time using the extracted model parameters (112, 212) and weather data (204), building data (202) and/or storage data (222) corresponding to the second time period.

2. The system of claim 1, wherein the state data for devices within the building includes activated state data and deactivated state data with corresponding time stamps.

3. The system of claim 1, wherein the extracted data includes delta state data for the environment within the building;
wherein the delta state data includes data representing a change from a previous data point.

4. The system of claim 4, wherein the delta state data includes data corresponding to a temperature change within the building.

5. The system of claim 1, wherein the predicted state of the environment (226) includes predicted temperature of the building during the second time period.

6. The system of claim 1, wherein the streaming data includes non-stored data input into the model parameters (112, 212) to predict a state of the environment within the building (226) and to predict a state of the devices within the building for the second time period.

## Patentansprüche

1. System zur modellbasierten Datenspeicherung, umfassend:
eine Rechenvorrichtung, die dazu konfiguriert ist:
Umgebungsdaten (102) und Wetterdaten (104) innerhalb eines ersten Zeitraums von einer Anzahl von Sensoren zu extrahieren, die dazu benutzt werden, Zustandsdaten für eine Umgebung innerhalb eines Gebäudes und Zustandsdaten für Vorrichtungen innerhalb des Gebäudes zu bestimmen;
ein Modell (110) der thermischen Reaktion des Gebäudes auf Basis der extrahierten Daten zu erzeugen;
das erzeugte Modell (110) der thermischen Reaktion zu verwenden, um einen oder mehrere Modellparameter (112, 212) zu extrahieren, die dazu geeignet sind, auf Basis von Umgebungs- und Wetterdaten von der Anzahl von Sensoren während eines auf den ersten Zeitraum folgenden zweiten Zeitraums die Umgebung im Inneren des Gebäudes vorherzusagen und/oder einen Zustand von Vorrichtungen im Inneren des Gebäudes vorherzusagen;
die Modellparameter (112, 212) zu speichern;
die erzeugten Daten des Modells (110) der thermischen Reaktion zu verwerfen; und
einen vorhergesagten Zustand der Umgebung (226) innerhalb des Gebäudes und einen vorhergesagten Zustand der Vorrichtungen innerhalb des Gebäudes für die zweite Zeit unter Verwendung der extrahierten Modellparameter (112, 212) und Wetterdaten (204), Gebäudedaten (202) und/oder Speicherdaten (222) entsprechend dem zweiten Zeitraum zu bestimmen.

2. System nach Anspruch 1, wobei die Zustandsdaten für Vorrichtungen innerhalb des Gebäudes Daten eines aktivierten Zustands und Daten eines deaktivierten Zustands mit entsprechenden Zeitstempeln beinhalten.

3. System nach Anspruch 1, wobei die extrahierten Daten Delta-Zustandsdaten für die Umgebung innerhalb des Gebäudes beinhalten,
wobei die Delta-Zustandsdaten Daten beinhalten, die eine Änderung zu einem vorherigen Datenpunkt darstellen.

4. System nach Anspruch 4, wobei die Delta-Zustandsdaten Daten beinhalten, die einer Temperaturänderung innerhalb des Gebäudes entsprechen.

5. System nach Anspruch 1, wobei der vorhergesagte Zustand der Umgebung (226) eine vorhergesagte Temperatur des Gebäudes während des zweiten Zeitraums beinhaltet.

6. System nach Anspruch 1, wobei die Streamingdaten eine nicht gespeicherte Dateneingabe in die Modellparameter (112, 212) beinhalten, um einen Zustand der Umgebung innerhalb des Gebäudes (226) vorherzusagen und um einen Zustand der Vorrichtungen innerhalb des Gebäudes für den zweiten Zeitraum vorherzusagen.

## Revendications

1. Système de mémorisation de données centrée sur un modèle, comprenant :
un dispositif informatique configuré pour :
extraire des données environnementales (102) et des données météorologiques (104) sur une première période de temps provenant d'un certain nombre de capteurs utilisés pour déterminer des données d'état d'un environnement à l'intérieur d'un bâtiment et des données d'état de dispositifs à l'intérieur du bâtiment ;
générer un modèle de réponse thermique (110) du bâtiment sur la base des données extraites ;
utiliser le modèle de réponse thermique (110) généré pour extraire un ou plusieurs paramètres de modèle (112, 212) qui sont adaptés pour prédire l'environnement à l'intérieur du bâtiment et/ou pour prédire un état de dispositifs à l'intérieur du bâtiment sur la base de données environnementales et météorologiques provenant du certain nombre de capteurs pendant une deuxième période de temps consécutive à la première période de temps ;
mémoriser les paramètres de modèle (112, 212) ;
rejeter les données de modèle de réponse thermique (110) généré ; et
déterminer un état prédit de l'environnement (226) à l'intérieur du bâtiment et un état prédit des dispositifs à l'intérieur du bâtiment pendant la deuxième période en utilisant les paramètres de modèle (112, 212) extraits et des données météorologiques (204), des données de bâtiment (202) et/ou des données de mémorisation (222) correspondant à la deuxième période de temps.

2. Système selon la revendication 1, dans lequel les données d'état de dispositifs à l'intérieur du bâtiment incluent des données d'état activées et des données d'état désactivées avec des horodatages correspondants.

3. Système selon la revendication 1, dans lequel les données extraites incluent des données d'état delta de l'environnement à l'intérieur du bâtiment ;
dans lequel les données d'état delta incluent des données représentant un changement par rapport à un point de données précédent.

4. Système selon la revendication 4, dans lequel les données d'état delta incluent des données correspondant à un changement de température à l'intérieur du bâtiment.

5. Système selon la revendication 1, dans lequel l'état prédit de l'environnement (226) inclut la température prédite du bâtiment pendant la deuxième période de temps.

6. Système selon la revendication 1, dans lequel les données transmises en continu incluent des données non mémorisées entrées dans les paramètres de modèle (112, 212) pour prédire un état de l'environnement à l'intérieur du bâtiment (226) et pour prédire un état des dispositifs à l'intérieur du bâtiment pendant la deuxième période de temps.
